**Europäisches Patentamt**

**European Patent Office**

**Office européen des brevets**

(19)

(11) **EP 1 443 563 A2**

(12) **EUROPEAN PATENT APPLICATION**

(43) Date of publication:
**04.08.2004 Bulletin 2004/32**

(51) Int Cl.⁷: $H01L\ 27/00$, $H01L\ 51/20$

(21) Application number: **04001889.7**

(22) Date of filing: **29.01.2004**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **03.02.2003 JP 2003025730**

(71) Applicant: **SEIKO EPSON CORPORATION Shinjuku-ku, Tokyo 163-0811 (JP)**

(72) Inventor: **Yotsuya, Shinichi Suwa-shi Nagano-ken 392-8502 (JP)**

(74) Representative: **Hoffmann, Eckart, Dipl.-Ing. Patentanwalt, Bahnhofstrasse 103 82166 Gräfelfing (DE)**

(54) **Light emitting display panel and method of manufacturing the same**

(57)    A light emitting display panel (12), comprises a transparent substrate (1) equipped with a light emitting element (5) on a first surface (1a) thereof, a second surface (1b) of the transparent substrate defining a display surface; and a microlens array (9) is disposed above the second surface of the transparent substrate (1). A method of manufacturing the light emitting display panel (12) comprises the step of adhering the microlens array (9) to the second surface (1b) of the transparent substrate (1) via adhesive (10).

FIG. 1

OUTSIDE LIGHT

EP 1 443 563 A2

## Description

The present invention relates to a light emitting display panel using a light emitting element such as an organic electroluminescent element (hereinafter referred to as an organic EL element) and a manufacturing method of the light emitting display panel.

In a conventional light emitting display panel, a light emitting layer (a plurality of light emitting elements) having a plurality of transparent electrodes parallel to each other, an organic EL material layer, and a metal electrode stacked in this order, is formed on a transparent substrate. Further, terminal lines extended from the transparent electrodes and the metal electrode are formed to connect a drive circuit. The light emitting layer is held in a sealed environment provided by adhering a sealing case to the transparent substrate via an adhesive, thus preventing deterioration of the light emitting efficiency that might otherwise be caused by atmospheric moisture (see for example JP 2000-243556 A, page 3, FIG. 1)

The conventional light emitting display panel as described above has a structure in which the light emitting elements are disposed on one surface of the transparent substrate and display light is emitted from the other surface of the transparent substrate. However, since the emitted light is diffused in various directions and the refractive index of the transparent substrate made of glass (typically 1.50 in case of glass) is higher than that of the atmosphere (air, typically 1.00), total reflection occurs at the boundary face between the transparent substrate and the atmosphere on the emitted light that makes a larger angle with the normal to the surface of the transparent substrate than the critical angle. This causes a problem of lower light-extraction efficiency because such light is diffused in the transparent substrate or disappears by attenuation through the transparent substrate. To be a little more specific, the light-extraction efficiency of the emitted light is given by the following equation (1) where n denotes the refractive index of the transparent substrate:

$$\text{Light-extraction efficiency} = 1 /(2n^2) \qquad (1)$$

If the refractive index of glass, n = 1.50 is applied to this equation, the light-extraction efficiency is 0.22, which shows that only 22 % of emitted light can be utilized resulting in a large energy loss.

In addition, since a mirror finish is applied to the other surface of the transparent substrate, i.e., the surface that defines a display surface, incident light from outside is reflected by this surface, which causes a problem that the reflected light makes the display on the light emitting display panel difficult to be recognized by mingling with the light emitted by the light emitting elements.

The present invention is intended to cope with the problems described above. Therefore, one object of the present invention is to provide a light emitting display panel that has a higher light-extraction efficiency than prior art panels, prevents reflection of incident light from outside, and has an improved appearance of the display, an improved current efficiency, and an extended life time of the panel. Another object of the invention is to provide a method of manufacturing such light emitting display panel.

These objects are achieved by a light emitting display panel as claimed in claim 1 and a method as claimed in claims 12 and 14, respectively. Preferred embodiments of the invention are subject-matter of the dependent claims.

According to the claimed structure, light from the light emitting elements is hardly reflected by a boundary face between the transparent substrate and the atmosphere and also the incident light from outside can be diffusely reflected. Thus the light-extraction efficiency can be improved resulting in an improvement of the light-emission efficiency, and, furthermore, the display can be easily recognized because reflection of the incident light is prevented.

In addition, in the light emitting display panel described above, the microlens array can be adhered to the second surface of the transparent substrate via an adhesive. According to this structure, concavity and convexity can be easily formed on the display face of the transparent substrate.

Furthermore, in the light emitting display panel described above, the microlens array can be disposed on a first surface of a substrate made of the same material as the transparent substrate, and a second surface of the substrate can be adhered to the second surface of the transparent substrate via adhesive. According to this structure, since the microlens array can be formed on a flat surface, microfabrication technologies can be utilized to form a very fine microlens array. Thus the reflection of the incident light can be prevented to provide clearer image display in a bright condition, and also the microlens can be manufactured with fewer manufacturing steps, which can reduce a manufacturing cost of the light emitting display panel.

In the light emitting display panel described above, the microlens array can be made of a transparent material having a refractive index substantially equal to or higher than that of the transparent substrate. According to this structure, since, from a view point of a refractive index, the microlens array is not less than the transparent substrate, the light from the light emitting elements is output with little reflection by the boundary face between the transparent substrate and the microlens array. Moreover, the incident light from the transparent substrate side to the microlens array side with a large incident angle is output with a smaller angle than the incident angle. In other words, since the angle of a large part of the output light can be reduced to be smaller than the critical angle, only little light is reflected by the total reflection phenomenon. Thus the light-extraction efficiency can be improved resulting in improvement of the light-emission efficiency. Moreover, since the power consumption necessary for light emission can be reduced, life of the light emitting elements can be extended.

Still further, in the light emitting display panel described above, the adhesive can be made of a transparent material having a refractive index that is substantially equal to or higher than that of the transparent substrate and substantially equal to or lower than that of the microlens array. According to this structure, since, from a view point of a refractive index, the microlens array is not less than the adhesive and the adhesive is not less than the transparent substrate, the light from the light emitting elements is output with little reflection caused by the total reflection at the boundary faces between the transparent substrate and the adhesive and between the adhesive and the microlens array, thus enhancing the light-extraction efficiency.

Moreover, in the light emitting display panel described above, the adhesive can be made of a material that cures at a temperature lower than that of a glass transition point of a material forming the light emitting element. According to this structure, it can be prevented that the heat-sensitive light emitting elements are damaged by heat applied to cure the adhesive when adhering the microlens array with the transparent substrate.

Furthermore, in the light emitting display panel described above, the adhesive can be made of a material cured by visible radiation. According to this structure, it can be prevented that the light emitting elements sensitive to heat and ultraviolet lays are damaged by ultraviolet lays irradiated to cure the adhesive when adhering the microlens array with the transparent substrate.

In the light emitting display panel described above, the microlens array can comprise a plurality of convex microlenses sized within a range of 1 through 100 micrometer. According to this structure, a high efficiency of reducing the incident light reflection can be obtained, and thus enhancing the light-extraction efficiency of the light emitting elements.

Furthermore, in the light emitting display panel described above, the light emitting element can be formed by sequentially stacking at least a transparent electrode, a light emitting layer, and a metal electrode above the first surface of the transparent substrate in this order.

Still further, in the light emitting display panel described above, the light emitting layer can comprise a layer of an organic EL material.

In addition, in the light emitting display panel described above, an antireflective agent is applied on at least the second surface of the transparent substrate and the surface of the microlens array. According to this structure, reflection of the light emitted from the light emitting elements caused by the total reflection phenomenon and reflection of the incident light from outside can be reduced, thus enhancing the light-extraction efficiency. Accordingly the light-emission efficiency can be improved, and the display appearance of the light emitting display panel can also be improved.

According to the method of claim 12, the microlens array can be easily formed of thermosetting resin. Thus the cost of the light emitting display panel can be reduced.

According to the method of claim 14, since a hard substrate is directly processed to form the microlens array, the microlens array is durable against wear even if it is exposed to outside. Thus a light emitting display panel having a durable surface can be provided.

Preferred embodiments of the invention will be described in detail hereinafter with reference to the drawings, in which:

FIG. 1     schematically illustrates the structure of a first embodiment of the present invention;

FIG. 2     illustrates how the microlens array is applied to the substrate in the first embodiment;

FIG. 3     illustrates steps of a manufacturing process of a microlens array according to the first embodiment;

FIG. 4     schematically illustrates the structure of a second embodiment of the present invention;

FIG. 5     illustrates steps of a manufacturing process of a microlens array according to the second embodiment; and

FIG.6     illustrates steps of a manufacturing process of a microlens array according to a third embodiment.

## First embodiment

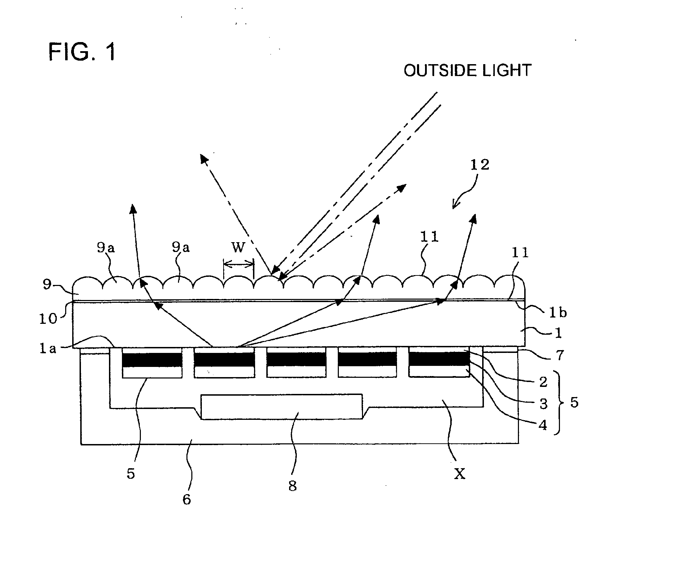

FIG. 1 illustrates the structure of a first embodiment of the present invention. In the figure, the reference numeral 1 denotes a transparent substrate. A plurality of light emitting elements (organic EL elements) 5 are disposed on a first surface 1a (the lower surface in Fig. 1) of the transparent substrate 1. Each of the light emitting elements 5 is formed by sequentially stacking a transparent electrode 2 made of indium tin oxide (hereinafter referred to as ITO) or the like, an organic EL material layer 3 formed of a light emitting functional layer or multiple layers including at least the light emitting functional layer, and a metal electrode 4. A sealing member 6 made of, for example, glass is disposed on the first surface 1a of the transparent substrate 1 via an adhesive 7 to seal the surrounding area of the light emitting elements. The sealing member 6 prevents the light emission property of the light emitting elements 5 from deteriorating with moisture. A desiccating agent 8 is disposed on an inner surface of the sealing member 6 within a space X formed between the sealing member 6 and the transparent substrate 1 for drying the space X to prevent the light emission property of the light emitting elements 5 from deteriorating with moisture.

A microlens array 9 made of a transparent material whose refractive index is substantially equal to or higher than that of the material forming the transparent substrate 1, such as acrylic resin or epoxy resin, is adhered to the other (second) surface 1b (the upper surface in Fig. 1) of the transparent substrate 1 via an adhesive 10. Since a plurality of convex microlenses (hereinafter referred to as convex lenses) 9a are disposed on the second surface of the transparent substrate1 without any spaces, the surface is uneven. Note that the size (width) W of each of the convex lenses 9a is preferably in a range of 1 through 100 micrometer. This is because, if the width W is less than 1 micrometer, unevenness of the surface of the microlens array 9 becomes too small to sufficiently reduce the reflection of the incident light from outside (the dashed line arrows in FIG. 1), whereas, if the width W exceeds 100 micrometer, total reflection often occurs in the microlens array 9 especially in the convex lenses 9a resulting in a decline in extraction efficiency of the emitted light (the solid line arrows in FIG. 1).

The adhesive 10 is made of transparent thermosetting resin whose refractive index is substantially equal to or lower than that of the microlens array 9 and substantially equal to or higher than that of the transparent substrate 1. The thermosetting resin that cures at a temperature lower than the lowest one of glass transition points (Tg points) of organic materials forming the light emitting element 5 is recommended. More preferably, the thermosetting resin should cure at a temperature of 10 or more degrees centigrade lower than the lowest Tg point. This is because the light emitting elements 5 that are sensitive to heat should be prevented from being damaged when the microlens array 9 is adhered to the transparent substrate 1. Moreover, since the light emitting elements 5 are sensitive also to ultraviolet light (UV light), a thermosetting resin that cures with visible light radiation is also preferable. Furthermore, an antireflection (AR) coating 11 as an antireflection agent, is applied to the surfaces of the microlens array 9 and the transparent substrate 1 to prevent reflection of light emitted from the light emitting elements 5 and reflection of incident light from outside.

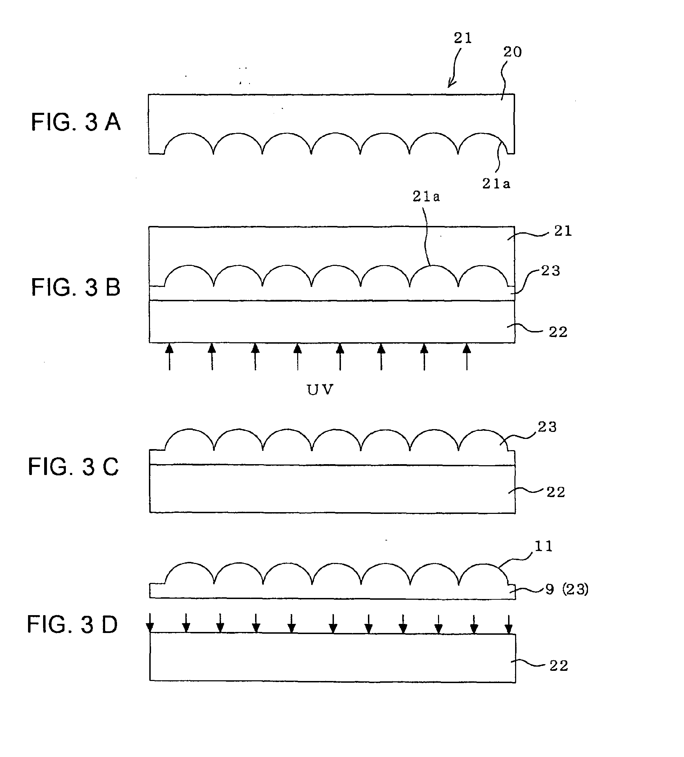

A method of manufacturing the microlens array 9 is explained hereinafter with reference to the process chart shown in FIG. 3.

(A) Firstly, polysilicon is applied to an outer surface of a quartz glass plate 20. The holes in the polysilicon that is used as a mask are for etching concave portions 21a in the mold. Then the quartz glass plate is wet-etched to form the mold 21. Then a water repellent finish is applied to the mold 21, especially the side of concave portions 21a, by blowing thereto carbon fluoride (CF) gas that prevents adhesion.

(B) Next, after applying the same water repellent finish to one surface (the upper surface) of a glass plate 22, thermosetting resin 23 that is to form the microlens array 9 is applied to the one surface (the upper surface) of the glass plate 22 with a predetermined thickness. The surface of mold 21 having the concave portions 21a formed therein is then pressed onto the resin 23 in vacuum so that no bubbles invade between the mold 21 and the resin 23. Then the resin 23 is irradiated with light such as UV light from the other surface (the lower surface) of the glass plate 22 to mold the resin 23 into the shape of the mold 21 and to cure the thus shaped resin 23.

(C) Next, the mold 21 is peeled off the cured resin 23. Since the water repellent finish had been applied to the side of the mold 21 with the concave portions 21a, it is easy to peel off the mold.

(D) Then, after the resin 23 has been peeled off the glass plate 22, the AR coating is applied to the surface of the resin 23 to complete the microlens array 9. Since the water repellent finish had also been applied to the glass plate 22, it is easy to peel off the thermosetting resin.

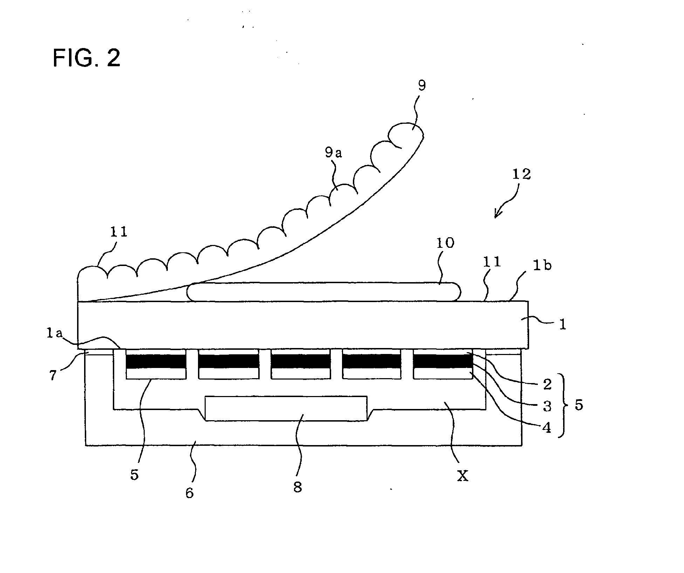

The microlens array 9 thus manufactured is adhered to the second surface 1b (the upper surface) of the transparent substrate 1 via the adhesive 10 as shown in FIG. 2, the transparent substrate 1 having the plurality of light emitting elements 5 on the first surface 1a (the lower surface) thereof sealed with the sealing member 6. This assembly, together with a circuit board not shown in the drawings having a drive circuit for driving the light emitting elements 5, forms the light emitting display panel 12.

In the light emitting display panel 12 thus structured, one or more desired ones of the light emitting elements 5 emit light under the control of the drive circuit in the circuit board, and the light is emitted to the outside via the transparent substrate 1 and the microlens array 9. In this case, since the refractive index of the adhesive 10 is smaller than that of the microlens array 9 and the refractive index of the transparent substrate 1 is smaller than that of the adhesive 10, the light from the light emitting elements 5 can be emitted without being reflected at any boundary surfaces between the transparent substrate 1 and the adhesive 10 or between the adhesive 10 and the microlens array 9. In addition, since the refractive index of the microlens array 9 is higher than those of the transparent substrate 1 and the adhesive 10, light incident from the transparent substrate side to the microlens array side with a large incident angle is output with a smaller angle than the incident angle. In other words, since the angle of a large part of the output light can be reduced to be smaller than the critical angle, only little light is reflected by the total reflection phenomenon. Thus the extraction efficiency of the light from the light emitting elements 5 can be improved resulting in an improvement of the light-emission efficiency. Moreover, since the power consumption necessary for light emission can be reduced, the life time of the light emitting elements 5 can be extended.

Moreover, since the refractive index of the microlens array 9 is higher than that of room air, the light from the microlens array side could be reflected by the boundary face between the microlens array 9 and the room air. However, since the surface of the microlens array 9 is made uneven by the convex lenses 9a, the light can hardly be reflected but rather be emitted. Further, incident light from outside can also be reflected diffusely by the uneven surface of the microlens array 9. Thus the light-extraction efficiency can be improved resulting in an improvement of the light-emission efficiency, and it is also possible to make the display to be easily recognized by preventing reflection of the incident light.

Also, since the surfaces of the transparent substrate 1 and the microlens array 9 are coated with the AR coating 11, the reflection of the light emitted by the light emitting elements 5 and also the incident light from outside can be even further prevented. Accordingly the light-emission efficiency can be improved, and the display appearance of the light emitting display panel 12 can also be improved.

Furthermore, since the microlens array 9 is made of thermosetting resin that is easy to be molded, the cost of the light emitting display panel 12 can be reduced.

Accordingly, the light emitting display panel 12 as described above is suitable for articles that are expected to be used in bright places or mobile equipments that require low power consumption, such as a cellular phone, a personal digital assistant (PDA), or an in-vehicle TV.

**Second embodiment**

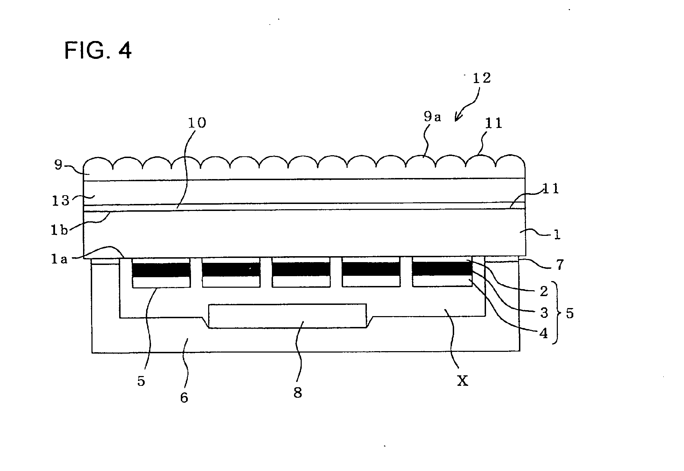

FIG. 4 illustrates the structure of a second embodiment of the present invention. In the second embodiment, the light emitting display panel 12 of the first embodiment further comprises a substrate 13 which, instead of the microlens array 9, is adhered to the second surface 1b (the upper surface in the figure) of the transparent substrate 1 via the adhesive 10, the substrate 13 being made of the same material, e.g. glass, as the transparent substrate 1 and having the microlens array 9 disposed on one surface thereof (the upper surface in the figure).

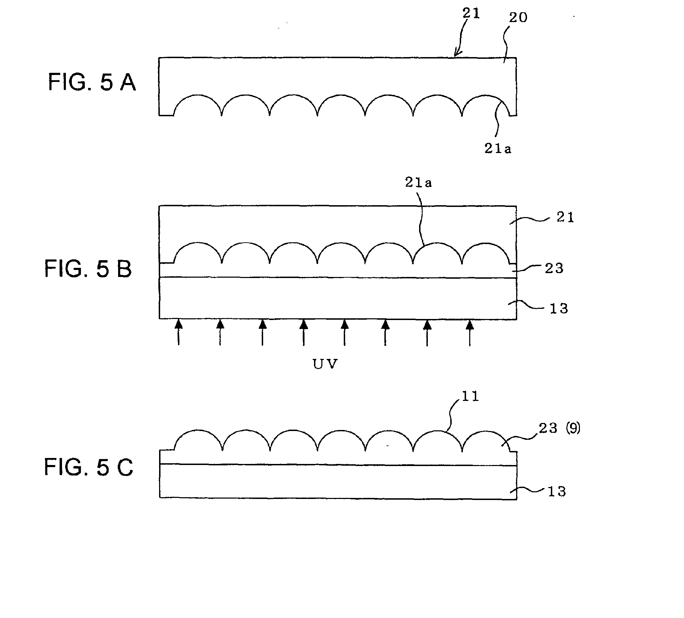

A method of manufacturing the microlens array 9 is explained hereinafter with reference to the process chart shown in FIG. 5.

(A) Firstly, polysilicon is applied on a outer surface of a quartz glass plate 20 that is to become a mold for the microlens array 9 with holes provided in one surface (the lower surface) of the quartz glass plate 20, each hole corresponding to a respective one of the convex lenses 9a, and then the quartz glass plate is wet-etched to form the mold 21. Then a water repellent finish is applied to the mold 21, especially to the side of concave portions 21a thereof by blowing thereto carbon fluoride (CF) gas that prevents adhesion.

(B) Next, thermosetting resin 23 that is to form the microlens array 9 is applied to the one surface (the upper surface in the figure) of the substrate 13 with a predetermined thickness. The mold 21 is then placed on the resin 23 in vacuum so that no bubbles invade between the mold 21 and the resin 23. Then the resin 23 is irradiated with light such as UV light from the other surface (the lower surface) of the substrate 13 to mold the resin 23 into the shape of the mold 21 and to cure the resin 23.

(C) Next, the mold 21 is peeled off the cured resin 23. Then, the AR coating is applied to the surfaces of the substrate 13 and the resin 23 to complete the microlens array 9 with the substrate 13 adhered thereto. Since the water repellent finish had been applied to the mold 21, it is easy to peel off the mold.

An assembly of the microlens array 9 and the substrate 13 thus manufactured is, as shown in FIG. 4, adhered to the second surface 1b (the upper surface in the figure) of the transparent substrate 1 via the adhesive 10 so that the microlens array 9 side is positioned on the upper side, the transparent substrate 1 having the plurality of light emitting elements 5 on its first surface 1a (the lower surface in the figure) sealed with the sealing member 6. This assembly, together with a circuit board not shown in the drawings having a drive circuit for driving the light emitting elements 5, forms the light emitting display panel 12.

With this structure, substantially the same action and effectiveness as those of the first embodiment can be obtained. In addition to this, since the microlens array 9 can be formed on a flat surface of the substrate 13, microfabrication technologies can be utilized to make the microlens array 9 very fine. Thus the reflection of the incident light can be prevented to provide clearer image display in a bright surrounding. Also, the microlens can be manufactured with fewer manufacturing steps, which can reduce the manufacturing cost of the light emitting display panel 12.

**Third embodiment**

The third embodiment corresponds to the second embodiment with the difference that the substrate 13 to which the microlens array 9 is adhered, is replaced by a substrate 14 on which the microlens array 9 is formed by processing the substrate 14 itself.

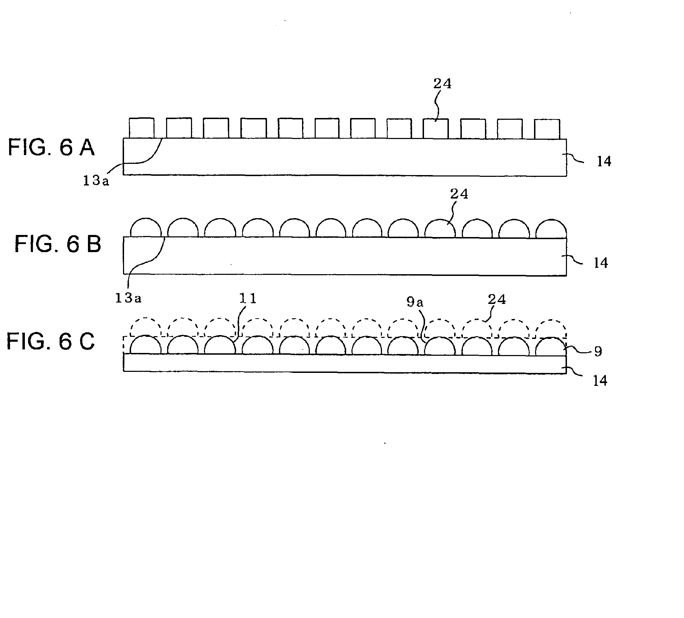

A method of manufacturing the microlens array 9 is explained hereinafter with reference to the process chart shown in FIG. 6.

(A) Firstly, one surface of the substrate 14 made of the same material as the transparent substrate 1 is coated with photosensitive resin 24, and the photosensitive resin 24 is patterned by a photolithography process so that the photosensitive resin 24 is formed on each pixel corresponding to a convex lens 9a of the microlens array 9. In other words, as shown in Fig. 6A, the resin 24 is formed into a pattern that corresponds to the pattern of microlenses 9a in the microlens array 9 to be formed.

(B) Then the patterned photosensitive resin 24 is shaped into convex portions (each portion resembling a convex lens 9a of the microlens array 9 to be formed) by heating to round the surface thereof (thermal reflow).

(C) After that, the shape of the convex lenses 9a formed by the photosensitive resin 24 is transferred to the substrate 14 by a dry-etching method to form the microlens array 9 comprising a plurality of convex lenses 9a on the one surface of the substrate 14 (the upper surface in the figure). Then the surfaces of the substrate 14 and the microlens array 9 are coated with the AR coating.

The microlens array 9 thus formed by directly processing the substrate 14 is adhered to the second surface 1b of the transparent substrate 1 via the adhesive 10 so that the microlens array side is positioned on the upper side, the transparent substrate 1 having the plurality of light emitting elements 5 on its first surface 1a sealed with the sealing member 6. This assembly, together with a circuit board not shown in the drawings having a drive circuit for driving the light emitting elements 5, forms the light emitting display panel 12. Note that this assembly is not shown in any of the drawings but corresponds to that shown in Fig. 4 if the reference numeral 14 is substituted for 13 in Fig. 4.

With this structure, substantially the same action and effectiveness as those of the second embodiment can be obtained. In addition to this, since the microlens array 9 itself is made of glass that is hard, the microlens array 9 is durable against wear even if it is exposed to the outside. Thus a light emitting display panel 12 having a surface durable against scratches and difficult to be damaged can be provided.

## Claims

1. A light emitting display panel, comprising:

    a transparent substrate (1) equipped with one or more light emitting elements (5) on a first surface (1a) thereof, a second surface (1b) of the transparent substrate (1) defining a display surface; and
    a microlens array (9) disposed on or above the second surface (1b) of the transparent substrate (1).

2. The panel according to Claim 1, wherein; the microlens array (9) is adhered to the second surface (1b) of the transparent substrate (1) by means of an adhesive (10).

3. The panel according to Claim 1, wherein
    the microlens array (9) is disposed on a first surface of a second substrate (13; 14) made of the same material as the transparent substrate (1); and
    a second surface of the second substrate (13; 14) is adhered to the second surface (1 b) of the transparent substrate (1) by means of an adhesive (10).

4. The panel according to any one of Claims 1 through 3, wherein the microlens array (9) is made of a transparent material having a refraction index substantially equal to or higher than that of the transparent substrate (1).

5. The panel according to any one of Claims 2 through 4, wherein the adhesive (10) is made of a transparent material having a refraction index that is substantially equal to or higher than that of the transparent substrate (1) and substantially equal to or lower than that of the microlens array (9).

6. The panel according to Claim 5, wherein the adhesive (10) is made of a material that cures at a temperature lower than that of the glass transition point of a material forming the one or more light emitting elements (5).

7. The panel according to Claim 5, wherein the adhesive (10) is made of a material cured by visible light radiation.

8. The panel according to any one of Claims 1 through 7, wherein the microlens array (9) comprises a plurality of convex microlenses (9a) sized within a range of 1 through 100 micrometer.

9. The panel according to any one of Claims 1 through 8, wherein the one or more light emitting element (5) are each formed by sequentially stacking at least a transparent electrode (2), a light emitting layer (3), and a metal electrode (4) in this order on the first surface (1a) of the transparent substrate (1).

10. The panel according to Claim 9, wherein the light emitting layer (3) comprises a layer of an organic electroluminescent material.

11. The panel according to any one of Claims 1 through 10, wherein an antireflective agent is applied to at least the second surface (1b) of the transparent substrate (1) and the surface of the microlens array (9).

12. A method of manufacturing a light emitting display panel equipped with one or more light emitting elements (5) on a first surface (1a) of a first transparent substrate (1) and a microlens array (9) on a second surface (1b) of the first transparent substrate (1), comprising:

    (a) coating a second transparent substrate (22; 13) with resin (23) that is to become the microlens array (9) ;
    (b) transferring the shape of the microlens array (9) to the resin (23) by pressing a mold (21) of the microlens array (9) against the resin;
    (c) curing the resin (23); and
    (d) forming the microlens array (9) by peeling off the mold (21) from the resin (23).

13. The method according to Claim 12 wherein step (d) comprises

    (e) peeling off the second transparent substrate (22) from the resin (23).

14. A method of manufacturing a light emitting display panel equipped with one or more light emitting elements (5) on a first surface (1a) of a first transparent substrate (1) and a microlens array (9) on a second surface (1b) of the first transparent substrate (1), comprising:

    (a) coating a second transparent substrate (14) with photosensitive resin (24);
    (b) patterning the photosensitive resin (24) by a photolithography process so that the photosensitive resin (24) remains in a pattern corresponding to the pattern of convex microlenses of the microlens array (9) to be formed;
    (c) shaping the patterned photosensitive resin into the form of convex microlenses by heating the photosensitive resin; and
    (d) forming the microlens array (9) by transferring a shape of the photosensitive resin to the second transparent substrate (14) by simultaneously dry-etching the photosensitive resin and the second transparent substrate.

FIG. 1

OUTSIDE LIGHT

FIG. 2

FIG. 3 A

FIG. 3 B

UV

FIG. 3 C

FIG. 3 D

FIG. 4

FIG. 5 A

FIG. 5 B

UV

FIG. 5 C

FIG. 6 A

24

13a

14

FIG. 6 B

24

13a

14

FIG. 6 C

11    9a    24

9

14